Europäisches Patentamt

**European Patent Office**

Office européen des brevets

(19)

(11) Numéro de publication **0 086 514**
B1

(12)

# FASCICULE DE BREVET EUROPEEN

(45) Date de publication du fascicule du brevet:
**31.07.85**

(51) Int. Cl.⁴: **H 03 G 3/20**, H 04 B 1/66

(21) Numéro de dépôt: **83200112.7**

(22) Date de dépôt: **26.01.83**

(54) **Dispositif de controle automatique de gain (CAG) à action rapide.**

(30) Priorité: **03.02.82 FR 8201722**

(43) Date de publication de la demande:
**24.08.83 Bulletin 83/34**

(45) Mention de la délivrance du brevet:
**31.07.85 Bulletin 85/31**

(84) Etats contractants désignés:
**DE FR GB**

(56) Documents cités:
**DE - A - 2 061 744**
**US - A - 3 544 970**
**US - A - 3 944 942**

**PATENTS ABSTRACTS OF JAPAN, vol. 6, no. 119, 3
juillet 1982, page 997 E-116**

(73) Titulaire: **TELECOMMUNICATIONS
RADIOELECTRIQUES ET TELEPHONIQUES T.R.T.,
88, rue Brillat Savarin, F-75013 Paris (FR)**
(84) Etats contractants désignés: **FR**

(73) Titulaire: **N.V. Philips' Gloeilampenfabrieken,
Groenewoudseweg 1, NL-5621 BA Eindhoven (NL)**
(84) Etats contractants désignés: **DE GB**

(72) Inventeur: **Van Uffelen, Jean-Pierre, SOCIETE CIVILE
S.P.I.D. 209 rue de l'Université, F-75007 Paris (FR)**
Inventeur: **Robillard, Daniel, SOCIETE CIVILE
S.P.I.D. 209 rue de l'Université, F-75007 Paris (FR)**
Inventeur: **Lebourg, Michel, SOCIETE CIVILE
S.P.I.D. 209 rue de l'Université, F-75007 Paris (FR)**

(74) Mandataire: **Charpail, François et al, Société Civile
S.P.I.D. 209, rue de l'Université, F-75007 Paris (FR)**

## Description

L'invention concerne un dispositif de contrôle automatique de gain (CAG) à action rapide, disposé dans la partie à fréquence intermédiaire d'un récepteur haute fréquence recevant les informations provenant de canaux de transmission multiples avec changement fréquent de canal, ledit dispositif comportant un amplificateur à CAG commandé lors de l'utilisation d'un canal par l'application d'une tension de commande dont la valeur numérique est prélevée dans une mémoire où elle a été inscrite pendant la précèdente utilisation dudit canal et transmise également à un additionneur pour être ajoutée algébriquement à la valeur numérique d'un signal de correction élaboré dans une chaîne de mesure et de comparaison de la tension de sortie de l'amplificateur à CAG afin de fournir la valeur numérique de la tension de commande corrigée.

Dans un poste émetteur-récepteur à modulation d'amplitude, un dispositif de CAG classique consiste en une boucle d'asservissement comprenant un amplificateur à gain variable inséré dans la partie à fréquence intermédiaire du récepteur et un circuit d'élaboration de la tension de commande obtenu par détection du signal en sortie de l'amplificateur. Un problème important et souvent difficile est l'optimisation des constantes de temps du dispositif dites de sensibilisation et de désensibilisation, la première étant la plus élevée et atteignant quelques centaines de millisecondes.

Dans certains équipements émetteurs-récepteurs utilisés spécialement pour les transmissions de données, celles-ci sont effectuées suivant des canaux multiples utilisés à cadence élevée. C'est le cas par exemple des systèmes à liaisons en évasion de fréquence habituellement conçus pour assurer le secret des transmissions et des systèmes à liaisons multipoints. L'intervalle de temps, relatif à un palier de fréquence ou à l'établissement de liaisons avec les points où sont situés divers correspondants pouvant être très court, les constantes de temps relativement élevées d'un dispositif à CAG classique constituent la principale limitation de tels systèmes.

Un dispositif de contrôle automatique du gain qui réagit plus rapidement eu égard à ces conditions particulières d'exploitation et dont la conception est identique à celle déjà mentionnée dans le préambule est décrit dans le brevet français n° 2 074 201 concernant un émetteurrécepteur permettant la transmission d'informations à fréquence variable. L'amplificateur à CAG est commandé par une mémoire constituée par une matrice à registre à décalage travaillant au rythme des changements de fréquence et ayant autant de positions mémorisées que le nombre de fréquences de la porteuse émise. La connaissance de l'état antérieur du niveau de tension de commande mis en mémoire et le fait que les changements de fréquence sont exploités avec une récurrence telle que les variations d'affaiblissement du signal entre deux utilisations consécutives de la même fréquence sont relativement faibles permettent de réduire le temps de réponse du dispositif. Il faut remarquer cependant que la valeur corrigée de la tension de commande transmise dans le premier registre n'est utilisable pour être réappliquée à l'amplificateur à CAG que lorsqu'elle est parvenue dans le dernier registre, c'est-à-dire au bout d'un intervalle de temps égal à la période de récurrence des fréquences successives.

La présente invention a pour but d'augmenter notablement la rapidité et la précision du dispositif en permettant de réutiliser la tension de commande immédiatement après sa correction et en introduisant un moyen de corriger les imperfections des divers éléments de la boucle d'asservissement.

A cet effet et conformément à l'invention, l'élaboration dudit signal de correction de la tension de commande pendant laquelle celleci est maintenue constante et l'application consécutive de ladite tension de commande corrigée à l'amplificateur à CAG afin de maintenir son niveau de sortie pratiquement constant, sont effectuées pendant une partie du temps d'utilisation dudit canal et peuvent être renouvelées une ou plusieurs fois pendant le reste de ce temps, la dernière valeur numérique de la tension de commande corrigée étant mise en mémoire, ladite mémoire étant une mémoire vive (RAM) adressée par un générateur d'adresses des différents canaux, ladite chaîne de mesure et de comparaison de la tension de sortie de l'amplificateur à CAG comportant de plus une mémoire morte (PROM) adressée en zones dans lesquelles sont rangées suivant différents niveaux mesurés de la tension de commande les valeurs prédéterminées correspondantes dudit signal de correction, réajustées pour tenir compte des imperfections de l'amplificateur à CAG et de ladite chaîne de mesure et de comparaison, ladite valeur numérique de la tension de commande prélevée dans la mémoire vive et transmise également à la mémoire morte, déterminant dans celle-ci la zone où l'on doit se situer pour sélectionner ledit signal de correction réajusté dont la valeur numérique est transmise à l'additionneur en sortie duquel on obtient la valeur numérique de la tension de commande corrigée, adaptée auxdites imperfections.

La description suivante en regard des dessins annexés le tout donné à titre d'exemple fera bien comprendre comment l'invention peut être réalisée.

La figure 1 représente le bloc diagramme du dispositif de contrôle automatique de gain à action rapide conforme à l'invention.

La figure 2 donne en coordonnées logarithmiques les formes idéale et expérimentale de la caractéristique de gain de l'amplificateur à CAG et de sa chaîne de mesure et de comparaison en fonction de son niveau d'entrée.

La figure 3 montre l'adressage en zones de la mémoire morte pour différentes valeurs mesurées de la tension de commande.

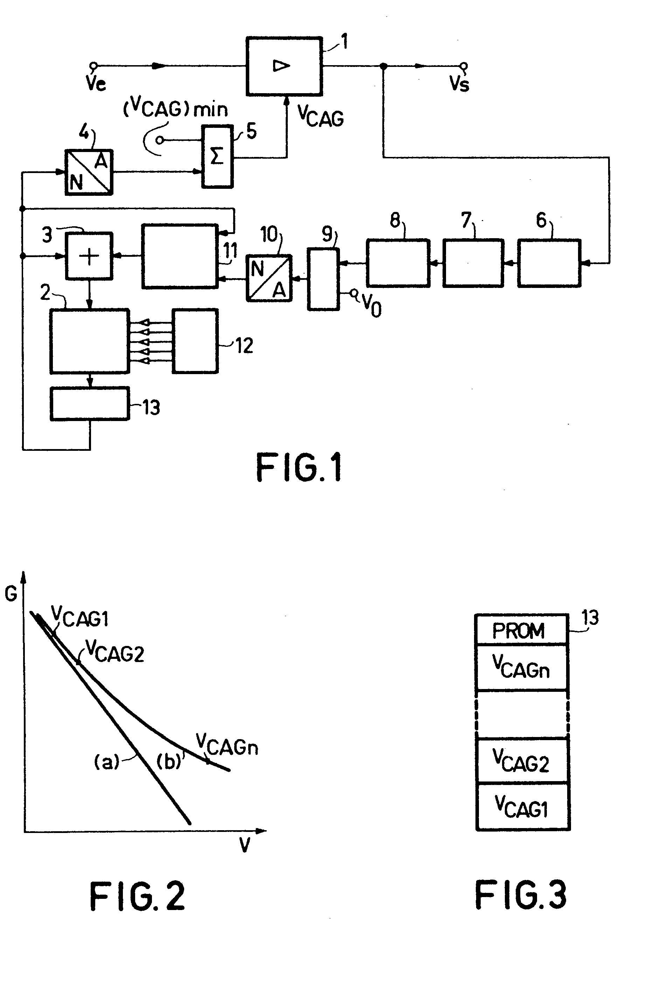

Le dispositif de contrôle automatique de gain à action rapide représenté sur la figure 1 comporte un amplificateur à CAG 1 disposé dans la partie à fréquence intermédiaire du récepteur d'un système à évasion de fréquence par exemple, avec un niveau d'entrée $V_e$ variable et un niveau de sortie $V_s$ que l'on cherche à maintenir constant par l'application d'une tension de commande dont la valeur numérique est prélevée dans une mémoire 2 lors de l'utilisation d'une fréquence donnée et ajoutée algébriquement dans un additionneur 3 à la valeur numérique d'un signal de correction élaboré dans une chaîne de mesure et de comparaison de la tension de sortie de l'amplificateur 1 pour fournir une valeur numérique de la tension de commande corrigée. La valeur numérique prélevée est celle qui a été mise en mémoire pendant la précédente utilisation de ladite fréquence. Cette valeur est transformée en analogique dans le convertisseur numérique-analogique 4 et ajoutée en 5 à une tension fixe $(V_{CAG})_{min}$ qui définit le cas échéant un seuil minimum à la tension de commande $V_{CAG}$ appliquée à l'amplificateur 1. Le signal $V_s$ en sortie de cet amplificateur est détecté et traité dans ladite chaîne de mesure et de comparaison qui comporte un redresseur 6, un intégrateur à remise à zéro 7, afin d'obtenir une valeur moyenne du signal et un amplificateur logarithmique 8 dont la tension de sortie linéaire en décibels est comparée dans un comparateur 9 à un seuil de tension de valeur $V_o$ égal à la tension qui serait engendrée en sortie de l'amplificateur logarithmique 8 si l'amplificateur à CAG 1 fournissait sa tension de sortie nominale $V_{so}$. On obtient ainsi en sortie du comparateur 9 un signal de correction positif ou négatif selon le sense de l'erreur et dont la valeur est convertie en numérique dans le convertisseur analogique-numérique 10 pour être transmise à l'additionneur 3.

Afin d'améliorer le temps de réponse de ce dispositif, il est avantageux de pouvoir réutiliser immédiatement après sa correction la valeur corrigée de la tension de commande transmise à la mémoire 2. A cet effet, ladite mémoire est, selon l'invention, une mémoire vive (RAM) recevant d'un générateur d'adresse 12 les adresses des différentes fréquences. L'adressage des fréquences qui peut être pseudoaléatoire provient d'un système de gestion du programme de sélection de fréquence non représenté. On suppose que la synchronisation des programmes de l'émmeteur et du récepteur est assurée par toute méthode appropriée par exemple au début de l'émission. Le signal numérique en sortie de la mémoire 2 est rééchantillonné dans un registre 13 avant sa conversion en analogique. Par ailleurs le dispositif conforme à l'invention permet également la correction des imperfections de l'amplificateur à CAG et de la chaîne de mesure et de comparaison de sa tension de sortie. Pour cela, une mémoire morte (PROM) 11 inséréé entre le convertisseur analogique-numérique 10 et l'additionneur 3 est adressée en zones dans lesquelles sont rangées suivant les valeurs expérimentales de la tension de commande les valeurs correspondantes du signal de correction, réajustées pour tenir compte de ces imperfections. La valeur numérique de la tension de commande prélevée dans la mémoire 2 et transmise à la mémoire 11 détermine dans celle-ci la zone où l'on doit se situer pour sélectionner le signal de correction réajusté. Ce signal est transmis à l'additionneur 3 dont la sortie fournit la valeur numérique de la tension de commande corrigée, adaptée auxdites imperfections.

Le fonctionnement de ce dispositif est le suivant. Si l'on passe à l'instant t de la fréquence $f_i$ à la fréquence $f_j$, la tension de commande $(V_{CAG})_i$ nécessaire au réglage de la boucle d'asservissement à l'instant t et à la fréquence $f_i$ est d'abord mise en mémoire dans la mémoire vive 2. La valeur $(V_{CAG})_j$ correspondant à la dernière utilisation du canal j est ensuite prélevée dans la mémoire 2, appliquée à l'amplificateur 1 et maintenue constante une partie du temps d'utilisation du canal j. Pendant cette partie de temps, on mesure et on traite la tension de sortie de l'amplificateur 1 et le rèsultat de cette mesure et de ce traitement est comparé à un seuil $V_o$ correspondant à sa tension de sortie nominale $V_{so}$. Un signal de correction $(\Delta V_{CAG})_j$ est déduit de cette comparaison.

La mémoire (PROM) il serait inutile si les conditions idéales suivant étaient réalisées: linéarité de la caractéristique de gain de l'amplificateur à CAG, obtention d'une fonction d'amplification logarithmique parfaite, absence de distorsion du système de mesure du signal de sortie de l'amplificateur à CAG, en particulier du redresseur. On aurait alors dans une représentation en coordonnées logarithmiques une variation linéaire de la caractéristique de gain G de l'amplificateur à CAG et de la chaîne de mesure et de comparaison de son signal de sortie en fonction du niveau d'entrée $V_e$ et une mesure rigoureuse en décibels.

La figure 2 sur laquelle on a représenté cette variation linéaire (a) avec la variation expérimentale (b) montre l'évolution de leur écart qui croît avec le niveau d'entrée. Différents niveaux de la tension de commande appliquée $V_{CAG1}$, $V_{CAG2}$, ... $V_{CAGn}$, sont indiqués en paramètre sur la caractéristique expérimentale.

Le rôle de la mémoire morte (PROM) 11 est de corriger les imperfections de l'amplificateur à CAG et de la chaîne de mesure et de comparaison de sa tension de sortie. A cet effet, la mémoire morte est divisée en différentes zones représentées sur la figure 3 qui correspondent chacune à une valeur de la tension $V_{CAG}$ fournie par la caractéristique expérimentale. Un double adressage de cette PROM par les informations numériques de la tension de commande et de son signal de correction permet d'établir une correspondance biunivoque entre le couple tension $(V_{CAG})_i$ appliqué et l'écart $V_s - V_{so}$ entre la

tension de sortie de l'amplificateur 1 et sa valeur nominale d'une part et le terme de correction $(\varDelta V_{CAG})_j$ d'autre part, la valeur prédéterminée du signal de correction $(\varDelta V_{CAG})'_j$ réajustée pour tenir compte de la non-linéarité de la caractéristique expérimentale du gain G étant rangée dans la zone de la mémoire 13 correspondant au niveau de $(V_{CAG})_j$ appliqué.

La valeur de $(\varDelta V_{CAG})'_j$ lue en mémoire de la PROM est ajoutée algébriquement dans l'additionneur 3 à la valeur de $(V_{CAG})_j$ issue de la RAM pour déterminer la valeur de la tension de commande corrigée.

Lorsque la correction a été effectuée, le registre à échantillonnage 13 autorise l'application de cette valeur de la tension de commande corrigée, via la mémoire 2 rendue transparente et le convertisseur numérique-analogique 4, à l'amplificateur 1 de manière à en modifier le gain pour rapprocher sa tension de sortie de la valeur nominale souhaitée. Ainsi dans un tel dispositif de CAG à action rapide, la correction est consécutive à la mesure, alors que dans un dispositif de CAG classique, la mesure et la correction se font simultanément. Pendant le reste du temps d'utilisation du canal j, les mêmes opérations de mesure et de correction peuvent être renouvelées une ou plusieurs fois selon le temps d'utilisation du canal au terme duquel la dernière valeur de la tension de commande corrigée est mise en mémoire.

Il faut remarquer qu'un dispositif de CAG à action rapide convient particulièrement bien aux systèmes à transmission de données dont les signaux ont un spectre assez bien concentré et relativement dépourvu de fréquences basses. On sait en effet que les fréquences les plus basses du spectre du signal modulant sont d'autant moins bien transmises qu'un tel dispositif est plus rapide, son temps de réponse tendant à se rapprocher du temps de montée du signal B. F.

**Revendication**

Dispositif de contrôle automatique de gain (CAG) à action rapide, disposé dans la partie à fréquence intermédiaire d'un récepteur haute fréquence recevant les informations provenant de canaux de transmission multiples avec changement fréquent de canal, ledit dispositif comportant un amplificateur à CAG (1) commandé lors de l'utilisation d'un canal par l'application d'une tension de commande $(V_{CAG})$ dont la valeur numérique est prélevée dans une mémoire (2) où elle a été inscrite pendant la précédente utilisation dudit canal et transmise également à un additionneur (3) pour être ajoutée algébriquement à la valeur numérique d'un signal de correction élaboré dans une chaîne (6 à 10) de mesure et de comparaison de la tension de sortie $(V_s)$ de l'amplificateur à CAG (1) afin de fournir la valeur numérique de la tension de commande corrigée, caractérisé en ce que l'élaboration dudit signal de correction de la tension de commande pendant laquelle celle-ci est maintenue constante et l'application consécutive de ladite tension de commande corrigée à l'amplificateur à CAG (1) afin de maintenir son niveau de sortie pratiquement constant, sont effectuées pendant une partie du temps d'utilisation dudit canal et peuvent être renouvelées une ou plusieurs fois pendant le reste de ce temps, la dernière valeur numérique de la tension de commande corrigée étant mise en mémoire (2), ladite mémoire étant une mémoire vive (RAM) adressée par un générateur d'adresses (12) des différents canaux, ladite chaîne (6 à 10) de mesure et de comparaison de la tension de sortie de l'amplificateur à CAG (1) comportant de plus une mémoire morte (PROM) (11) adressée en zones dans lesquelles sont rangées suivant différents niveaux mesurés de la tension de commande les valeurs prédéterminées correspondantes dudit signal de correction réajustées pour tenir compte des imperfections de l'amplificateur à CAG (1) et de ladite chaîne (6 à 10) de mesure et de comparaison, ladite valeur numérique de la tension de commande prélevée dans la mémoire vive (2) et transmise également à la mémoire morte (11), déterminant dans celle-ci la zone où l'on doit se situer pour sélectionner ledit signal de correction réajusté dont la valeur numérique est transmise à l'additionneur (3) en sortie duquel on obtient la valeur numérique de la tension de commande corrigée, adaptée auxdites imperfections.

**Patentanspruch**

Schnell wirkende automatische Verstärkungsregelungsanordnung (AVR) in dem ZF-Teil eines HF-Empfängers, der Daten von Mehrfachübertragungskanälen mit häufigem Kanalwechsel erhält, wobei die Anordnung einen AVR-Verstärker (1) aufweist, der beim Benutzen eines Kanals durch Zuführen einer Regelspannung $(V_{CAG})$ zu demselben geregelt wird, deren Digitalwert aus einem Speicher (2) erhalten wird, in dem dieser Wert beim vorhergehenden Gebrauch des Kanals gespeichert wurde, wobei dieser Digitalwert ebenfalls zum algebraischen Addieren desselben zu dem Digitalwert eines in einer Schaltungsanordnung (6 bis 10) zum Messen und Vergleichen der Ausgangsspannung $(V_s)$ des AVR-Verstärkers (1) einem Addierer (3) zugeführt wird um den Digitalwert der korrigierten Regelspannung zu erhalten, dadurch gekennzeichnet, daß die Verarbeitung des Regelspannungskorrektursignals, während der die Spannung konstant gehalten wird, und die darauffolgende Zufuhr der korrigierten Regelspannung zu dem AVR-Verstärker (1) um dessen Ausgangspegel nahezu konstant zu halten, während eines Teiles der Zeit ausgeführt wird, in der dieser Kanal benutzt wird, und ein oder mehrmals während der restlichen Zeit wiederholt werden kann, daß der letzte Digitalwert der korrigierten Regelspannung in einem Speicher (2) gespeichert wird, der ein Speicher mit wahlfreiem Zugriff (RAM) ist, der von einem Adressengenerator (12) der jeweiligen Kanäle adressiert wird, daß die Schaltungsanordnung (6 bis 10) zum Messen und Vergleichen der Ausgangsspannung des AVR-Verstärkers (1) weiterhin einen Festwertspeicher (PROM) (11) aufweist, der in Zonen adressiert ist, in denen sich entsprechend verschiedenen gemessenen Pegeln der Regelspannung die vorbestimmten, dem genannten Korrektursignal entsprechenden Werte befinden, die neu eingestellt sind um Unzulänglichkeiten des AVR-Verstärkers (1) und der genannten Meß- und Vergleichsschaltung (6 bis 10) zu berücksichtigen, daß der Digitalwert der Regelspannung, der dem Speicher (2) mit wahlfreiem Zugriff entnommen und ebenfalls dem Festwertspeicher (11) zugeführt wird, darin die Zone bestimmt zum Selektieren des neu eingestellten Korrektursignals, dessen Digitalwert dem Addierer (3) zugeführt wird, an dessen Ausgang der Digitalwert der korrigierten Regelspannung erhalten wird, die an die genannten Unzulänglichkeiten angepaßt ist.

## Claim

A fast automatic gain control (AGC) arrangement, provided in the intermediate frequency portion of a radio-frequency receiver receiving data from multiple transmission channels with frequent channel change, said arrangement comprising an AGC amplifier (1) which when a channel is in use is controlled by applying to it a control voltage ($V_{cag}$), whose digital value is obtained from a memory (2) in which this value was stored during the preceding use of that channel, and is also transferred to an adder (3) for adding it algebraically to the digital value of a correction signal produced in a circuit (6 to 10) for measuring and comparing the output voltage ($V_s$) of the AGC amplifier (1) in order to provide the digital value of the corrected control voltage, characterized in that processing said control voltage correction signal, during which operation the voltage is kept constant, and the subsequent application of the said corrected control voltage to the AGC amplifier (1) in order to keep its output level substantially constant, are effected during part of the time the said channel is employed and can be repeated once or several times during the remainder of said time, the last digital value of the corrected control voltage being stored in a memory (2), which is a random access memory (RAM) and is addressed by a generator (12) generating the adresses of the different channels, said circuit (6 to 10) for measuring and comparing the output voltage of the AGC amplifier (1) comprising furthermore a read-only memory (PROM) (11) which is addressed in zones in which there are arranged in accordance with different measured levels of the control voltage the corresponding predetermined values of the said correction signal re-adjusted to allow for the imperfections of the AGC amplifier (1) and of the said measuring and comparison circuit (6 to 10), said digital value of the control voltage read from the random access memory (2) being also transferred to the read-only memory (11) and determining therein the appropriate zone for the selection of said re-adjusted correction signal, the digital value of which is transferred to adder (3) at whose output the digital value of the corrected control voltage is obtained, adapted to the said imperfections.

FIG.1

FIG.2

FIG.3